# EUROPÄISCHE PATENTSCHRIFT

(11) **EP 4 339 592 B1**
(45) Veröffentlichungstag und Bekanntmachung des Hinweises auf die Patenterteilung: **14.10.2026**
(21) Anmeldenummer: 22195737.6
(22) Anmeldetag: 14.09.2022
(51) Int. Cl.: G01N 17/00, C23C 14/16, C23C 14/34, G01N 17/04

(54) **ANALYSEVERFAHREN MIT BESCHICHTETEM TRÄGER**
ANALYSIS METHOD WITH COATED SUPPORT
PROCÉDÉ D'ANALYSE UTILISANT UN SUPPORT REVÊTU

(43) Veröffentlichungstag der Anmeldung: 20.03.2024
(73) Patentinhaber: Hochschule für Technik und Wirtschaft Berlin, 12459 Berlin (DE)
(72) Erfinder: Jeberien, Alexandra, 10439 Berlin (DE); Alktash, Nivin, 14059 Berlin (DE); Szyszka, Bernd, 31246 Ilsede (DE)
(74) Vertreter: Taruttis, Stefan Georg

(56) Entgegenhaltungen:
- EP-A1- 3 620 232
- WO-A1-2011/141035
- CN-B- 101 109 692
- ALKTASH NIVIN ET AL: "Der beschleunigte Korrosionstest nach Oddy: Entwicklung und Herstellung reproduzierbarer Indikatorplättchen mittels Dünnschichtverfahren", ARCHÄOMETRIE UND DENKMALPFLEGE 2021, vol. 1719, 2021, XP093018132
- SHENG WANG ET AL: "An Improved Oddy Test Using Metal Films", STUDIES IN CONSERVATION, vol. 56, no. 2, 19 March 2011 (2011-03-19), US, pages 138 - 153, XP055557507, ISSN: 0039-3630, DOI: 10.1179/sic.2011.56.2.138
- CUI JIANGTAO ET AL: "Uniformity of Plasma Density and Film Thickness of Coatings Deposited Inside a Cylindrical Tube by Radio Frequency Sputtering", PLASMA SCIENCE AND TECHNOLOGY, INSTITUTE OF PHYSICS PUBLISHING, BRISTOL, GB, vol. 10, no. 5, October 2008 (2008-10-01), pages 560 - 564, XP020145392, ISSN: 1009-0630, DOI: 10.1088/1009-0630/10/5/08

## Beschreibung

Die Erfindung betrifft ein Verfahren zur Herstellung eines mit zumindest einer Metallschicht, nämlich einer Silberschicht, einer Kupferschicht und/oder einer Bleischicht, beschichteten Trägers, sowie ein damit durchführbares Verfahren zur Analyse von Materialien.

Bei der Lagerung von Kulturgütern wie bspw. Kunstwerken über eine längere Zeit, z.B. in Museen, kann es aufgrund äußerer Einflüsse zu Veränderungen an den Kulturgütern kommen, die deren Qualität und Wert verschlechtern können. Insbesondere können die in der Umgebung der lagernden Kulturgüter verwendeten Materialien einen qualitätsverschlechternden Einfluss ausüben, z.B. durch Emittieren von Schadstoffen, insbesondere von flüchtigen organischen Verbindungen wie z.B. Formaldehyd.

Zur Beurteilung des Einflusses von Materialien auf Kulturgüter wird ein Analyseverfahren durchgeführt, auch als Materialanalyse bezeichnet, z.B. der Oddy-Test. In einer bekannten Ausführungsform des Oddy-Tests wird eine Probe des zu untersuchenden Materials zusammen mit drei Detektionssonden, auch als Indikatoren bezeichnet, von denen eine Silber (Ag), eine Kupfer (Cu) und eine Blei (Pb) aufweist, in einen luftdicht verschließbaren Behälter gegeben. In den Behälter wird zusätzlich destilliertes Wasser gegeben. Dabei sind Probe, Indikatoren und Wasser so in dem Behälter angeordnet, dass sie sich gegenseitig jeweils nicht berühren. Der Behälter wird luftdicht verschlossen und für 28 Tage auf 60 °C erhitzt. Im Vergleich zu einem Kontrollbehälter, der keine Probe enthält, wird nach dem Erhitzen visuell das Korrosionsverhalten der Indikatoren bestimmt. Ist keiner der Indikatoren korrodiert, wird das analysierte Material als unbedenklich für den Einsatz in der Umgebung von Kulturgütern eingestuft.

Es ist bekannt, Plättchen oder Folien aus reinem Silber, reinem Kupfer bzw. reinem Blei als Indikatoren in Analyseverfahren wie dem Oddy-Test einzusetzen. Diese Indikatoren haben den Nachteil, dass sie vor ihrer Verwendung manuell zugeschnitten, gesäubert und montiert werden müssen, wodurch die Oberfläche und Metallstruktur der Indikatoren verschlechtert werden kann, was zu einer Beeinträchtigung der Aussagekraft und Reproduzierbarkeit des Analyseverfahrens führt. Auch beeinträchtigen Verunreinigungen der reinen Metalle die Qualität des Analyseverfahrens.

Die CN 101 109 692 A beschreibt die Herstellung von Indikatoren durch thermisches Aufdampfen von Metall auf Trägeroberflächen. Die daraus resultierenden Indikatoren weisen offenporige Metallschichten auf, die bereits an der Luft korrosionsanfällig sind.

Park et al., Solar Energy Materials 13, 351-365 (1986) beschreiben das Korrosionsverhalten von auf Glas aufgedampften Silberschichten.

Thicket and Lee, British Museum Occasional Papers (1996) beschreiben auf S. 14 die visuelle Beurteilung herkömmlicher Metallindikatoren nach Durchführung des Oddy-Tests und die Einordnung analysierter Materialien in "dauerhaft für die Lagerung geeignet" (P), "zeitweise für die Lagerung geeignet" (T) und "für die Lagerung ungeeignet" (U).

Alktash et al., Metalla Sonderheft 11/2021, 124-126, beschreibt für den Oddy-Test die Verwendung von auf Glas gesputtertem Silber, Kupfer und Blei, ohne jedoch die genauen Verfahrensbedingungen für das Sputtern anzugeben.

### Aufgabe der Erfindung

Der Erfindung stellt sich die Aufgabe, ein alternatives Verfahren zur Analyse von Materialien anzugeben, das insbesondere eine gute Reproduzierbarkeit aufweist, sowie ein alternatives Herstellungsverfahren für einen beschichteten Träger, mit dem das Analyseverfahren auszuführen ist, wobei sich das Herstellungsverfahren insbesondere durch eine hohe Reproduzierbarkeit auszeichnet.

### Beschreibung

Die Erfindung löst die Aufgabe mit den Merkmalen der Ansprüche und stellt insbesondere ein Verfahren zur Analyse von Materialien bereit, auch als Analyseverfahren bezeichnet, das die Schritte
a) Bereitstellen zumindest eines mit Silber und/oder Kupfer und/oder Blei beschichteten Trägers,
b) Anordnen des zumindest einen beschichteten Trägers in einem das zu analysierende Material enthaltenden Reaktionsgefäß, mit luftdichtem Verschließen des Reaktionsgefäßes,
c) Lagern des zumindest einen beschichteten Trägers in dem luftdicht verschlossenen Reaktionsgefäß bei 60 °C für zumindest 15 Tage, bevorzugt zumindest 20 Tage, zumindest 25 Tage, bis zu 40 Tage, z.B. für 28 Tage, vorzugsweise in einem Wärmeschrank, und
d) Analysieren des zumindest einen beschichteten Trägers auf Veränderungen
aufweist oder daraus besteht.

In dem Reaktionsgefäß, in dem der zumindest eine beschichtete Träger in Schritt c) des Analyseverfahrens gelagert wird, ist generell zusätzlich zumindest ein Reaktionszusatz enthalten, z.B. destilliertes Wasser und/oder Filterpapier und/oder Aktivkohle, sowie optional eine Probe angeordnet, die ein zu analysierendes Material ist. Dabei sind generell der zumindest eine beschichtete Träger, der zumindest eine Reaktionszusatz und die Probe räumlich voneinander beabstandet.

Während des Lagerns bei 60 °C in Schritt c) des Analyseverfahrens können reaktive Verbindungen, z.B. flüchtige organische Verbindungen, aus der Probe in das Volumen des Reaktionsgefäßes austreten und mit der auf dem zumindest einen beschichteten Träger angeordneten Metallschicht aus Silber und/oder Kupfer und/oder Blei reagieren. Dabei kann es zu Änderungen des beschichteten Trägers kommen, die erfindungsgemäß in Schritt d) des Analyseverfahrens analysiert werden.

Das Analysieren in Schritt d) des Analyseverfahrens ist generell bevorzugt ein optisches Analysieren und kann z.B. mittels Sichtanalyse erfolgen, oder kann das Auswerten zumindest eines von dem zumindest einen beschichteten Träger aufgenommenen Bildes umfassen, wobei das Auswerten auch mittels einer Computersoftware erfolgen kann, die eine künstliche Intelligenz umfassen kann. Dabei kann das aufgenommene Bild ein mit einer herkömmlichen Kamera aufgenommenes Bild sein, z.B. mit der Kamera eines Smartphones, oder z.B. ein mittels einer in einem Mikroskop bzw. einem Elektronenmikroskop angeordneten Aufnahmeeinheit aufgenommenes Bild.

Alternativ oder zusätzlich kann das Analysieren in Schritt d) das Messen eines spezifischen Widerstands umfassen, z.B. mittels eines Konduktometers, und/oder kann das Analysieren mittels Röntgendiffraktometrie und/oder mittels Röntgen-Spektrometrie und/oder mittels UV/Vis-Spektrometrie umfassen.

Generell kann das Analysieren in Schritt d) eine Endpunktanalyse umfassen oder daraus bestehen, insbesondere einen Vergleich mit einer Eichkurve und/oder einer parallel mitgeführten Blindprobe und/oder einem unbehandelten beschichteten Träger. Die Blindprobe ist dabei vorzugsweise ein beschichteter Träger, mit dem das erfindungsgemäße Analyseverfahren durchgeführt wurde, wobei keine Probe in dem Reaktionsgefäß angeordnet ist. Alternativ oder zusätzlich kann das Analysieren kontinuierlich erfolgen, z.B. durch Aufnehmen von Messwerten in Echtzeit oder in regelmäßigen oder unregelmäßigen Abständen, z.B. alle 10 min, alle 1 h, alle 12 h, alle 24 h, alle 3 d, oder alle 7 d.

Die in Schritt d) des Analyseverfahrens analysierten Veränderungen sind generell farbliche und/oder strukturelle Veränderungen in der Silberschicht und/oder Kupferschicht und/oder Bleischicht des beschichteten Trägers, die insbesondere durch Korrosion verursacht sein können. Die strukturellen Veränderungen können insbesondere ein Ablösen oder Sich-Auflösen der Metallschicht umfassen.

Auf der Grundlage der in Schritt d) des Verfahrens gewonnenen Messergebnisse kann für jedes untersuchte Material eine Zuordnung dahingehend getroffen werden, ob es für die Lagerung mit Kulturgütern geeignet, temporär geeignet oder ungeeignet ist. Die Zuordnung erfolgt generell bevorzugt durch subjektiv-visuelle Kategorisierung, z.B. anhand eines Ampel-Systems mit den Kategorien "dauerhaft für die Lagerung geeignet" (grün), "zeitweise für die Lagerung geeignet" (gelb), und "für die Lagerung ungeeignet" (rot). Die Zuordnung erfolgt durch rein makro- bzw. mikroskopischer sowie anhand vergleichender Betrachtung der Blind- und Referenzproben (Thicket and Lee, British Museum Occasional Papers, 1996, S. 14) . Ein zeitweise bzw. temporär geeignetes Material ist für die Lagerung mit Kulturgütern nur für einen Zeitraum von maximal 6 Monaten geeignet.

Der zumindest eine beschichtete Träger ist generell durch Aufsputtern beschichtet. Generell ist der beschichtete Träger in einem Verfahren hergestellt, auch als Herstellungsverfahren bezeichnet, das die Schritte
a) Bereitstellen zumindest eines Trägers, vorzugsweise genau eines Trägers, wobei der zumindest eine Träger bevorzugt Glas, z.B. Borosilikatglas, aufweist oder daraus besteht,
b) Aufsputtern von Silber und/oder Kupfer und/oder Blei auf den zumindest einen Träger, um zumindest einen beschichteten Träger zu erzeugen,
   wobei bevorzugt das Aufsputtern von Silber und Kupfer auf denselben Träger erfolgt, wobei bevorzugter das Aufsputtern von Silber in einen ersten Abschnitt des zumindest einen Trägers erfolgt und das Aufsputtern von Kupfer in einen davon beabstandeten zweiten Abschnitt desselben Trägers erfolgt, wobei optional das Aufsputtern von Blei in einen vom ersten und zweiten Bereich beabstandeten dritten Abschnitt desselben Trägers erfolgt,
   wobei noch bevorzugter das Aufsputtern von Silber und/oder Kupfer und/oder Blei in jeweils voneinander beabstandete Abschnitte auf derselben Oberfläche desselben Trägers erfolgt,
   wobei bevorzugt das Aufsputtern von Silber bis in eine Schichtdicke von 200 nm erfolgt, das Aufsputtern von Kupfer bis in eine Schichtdicke von 100 nm erfolgt, das Aufsputtern von Blei bis in eine Schichtdicke von 200 nm erfolgt,
   wobei bevorzugt das Aufsputtern durch Gasflusssputtern (GFS) und/oder Magnetronsputtern, z.B. durch Hochleistungsimpulsmagnetronsputtern (HIPIMS) erfolgt,
c) optional Anordnen des zumindest einen beschichteten Trägers im Vakuum oder in einer Inertatmosphäre, z.B. N₂ oder Edelgas, und Lagern bis zur weiteren Verwendung
aufweist oder daraus besteht.

Der beschichtete Träger wird durch die Merkmale des Herstellungsverfahrens definiert.

Ein mit dem Herstellungsverfahren hergestellter beschichteter Träger weist generell aufgesputtertes Silber und/oder aufgesputtertes Kupfer und/oder aufgesputtertes Blei als Indikatormaterial auf, jeweils als Schicht angeordnet, bevorzugt in voneinander beabstandeten Bereichen bzw. Abschnitten, und ist optional in einer Inertatmosphäre angeordnet. Bevorzugt weist ein beschichteter Träger eine aufgesputterte Silberschicht und eine davon beabstandete aufgesputterte Kupferschicht auf, sowie optional eine davon beabstandete aufgesputterte Bleischicht.

Der zumindest eine beschichtete Träger kann zur Durchführung des Analyseverfahrens in einem Testkit enthalten sein, z.B. zusammen mit destilliertem Wasser, einem Reaktionsgefäß, Filterpapier und/oder Aktivkohle.

Der zumindest eine Träger hat bevorzugt
- eine Breite von zumindest 5 mm, bevorzugt zumindest 10 mm, bis zu 50 mm, bevorzugt bis zu 30 mm, z.B. 12,5 mm oder 25 mm oder 37,5 mm,
- eine Länge von zumindest 5 mm, bevorzugt zumindest 15 mm, bis zu 50 mm, bevorzugt bis zu 30 mm, z.B. 25 mm, und
- eine Dicke von zumindest 0,5 mm, bevorzugt zumindest 1 mm, bis zu 5 mm, bevorzugt bis zu 3 mm, z.B. 1,1 mm.

Vorzugsweise erfolgt das Aufsputtern in Schritt b) des Herstellungsverfahrens von Silber und Kupfer auf denselben Träger, weiter bevorzugt in getrennte und voneinander beabstandete Abschnitte desselben Trägers, z.B. in voneinander beabstandete Abschnitte auf derselben Oberfläche des Trägers. Alternativ kann das Aufsputtern von Silber auf einen ersten Träger, das Aufsputtern von Kupfer auf einen zweiten Träger und das Aufsputtern von Blei auf einen dritten Träger erfolgen. Alternativ kann das Aufsputtern von Silber und Kupfer auf einen ersten Träger und das Aufsputtern von Blei auf einen zweiten Träger erfolgen.

Optional erfolgt das Aufsputtern von Blei auf denselben Träger, auf den Silber und/oder Kupfer aufgesputtert wird, z.B. in einen getrennten und von dem Silber und/oder Kupfer beabstandeten Abschnitt. Insbesondere kann Schritt b) des Herstellungsverfahrens das Aufsputtern von Silber, Kupfer und Blei auf einen gemeinsamen Träger umfassen, jeweils in getrennte und voneinander beabstandete Bereiche desselben Trägers. Dadurch hat das Verfahren den Vorteil, dass es die Durchführung einer Materialanalyse bzw. Gasanalyse mit einem einzigen beschichteten Träger ermöglicht.

Das Aufsputtern von Silber in Schritt b) des Herstellungsverfahrens erfolgt bevorzugt durch Gasflusssputtern, z.B. mittels einer Strömungsdüse. Dabei ist vorzugsweise die angelegte Leistung eine Leistung von zumindest 300 W, bevorzugt zumindest 310 W, zumindest 320 W, zumindest 330 W oder zumindest 340 W, bis zu 400 W, bevorzugt bis zu 390 W, bis zu 380 W, bis zu 370 W oder bis zu 360 W, z.B. 350 W. Denn es hat sich gezeigt, dass bei einer angelegten Leistung zwischen 300-400 W, z.B. bei 350 W dichtere und glattere Silberschichten auf den Träger aufgesputtert werden als bei einer höheren oder niedrigeren angelegten Leistung. Weiter ist bevorzugt der angelegte Vakuumdruck ein Druck von maximal 50 Pa, bevorzugt maximal 35 Pa, jedenfalls zumindest 10 Pa, z.B. 33 Pa. Beim Aufsputtern von Silber ist das Gasflusssputtern vorzugsweise ein dynamisches Beschichten im Puls-Modus, wobei in der bevorzugten Ausführungsform die Pulsfrequenz in dem Bereich zwischen 10 kHz und 200 kHz ist, z.B. bei 100 kHz, die Reverse-Spannung im Bereich zwischen 25 V und 125 V, z.B. bei 100 V, die Unterbrechungszeit ("pause time") im Bereich zwischen 0,5 µs und 4 µs, z.B. bei 2 µs. Das Aufsputtern von Silber erfolgt generell bis in eine Schichtdicke von zumindest 100 nm, bevorzugt zumindest 120 nm, zumindest 140 nm, zumindest 160 nm oder zumindest 180 nm, bis zu 350 nm, bevorzugt bis zu 300 nm oder bis zu 250 nm, z.B. 200 nm.

Das Aufsputtern von Kupfer in Schritt b) erfolgt bevorzugt durch Gasflusssputtern. Dabei ist vorzugsweise die angelegte Leistung eine Leistung von zumindest 400 W, bevorzugt zumindest 420 W, zumindest 440 W, zumindest 460 W oder zumindest 480 W, bis zu 600 W, bevorzugt bis zu 580 W, bis zu 560 W, bis zu 540 W oder bis zu 520 W, z.B. 500 W. Denn es hat sich gezeigt, dass bei einer angelegten Leistung im Bereich zwischen 400-600 W, z.B. bei 500 W dichtere und glattere Kupferschichten auf den Träger aufgesputtert werden als bei einer höheren oder niedrigeren angelegten Leistung. Weiter ist bevorzugt der angelegte Vakuumdruck ein Druck von maximal 50 Pa, bevorzugt maximal 35 Pa, jedenfalls zumindest 10 Pa, z.B. 33 Pa. Beim Aufsputtern von Kupfer ist das Gasflusssputtern vorzugsweise ein dynamisches Beschichten im Puls-Modus, wobei in der bevorzugten Ausführungsform die Pulsfrequenz in dem Bereich zwischen 10 kHz und 200 kHz ist, z.B. bei 100 kHz, die Reverse-Spannung im Bereich zwischen 25 V und 125 V, z.B. bei 100 V, die Unterbrechungszeit ("pause time") im Bereich zwischen 0,5 µs und 4 µs, z.B. bei 2 µs. Das Aufsputtern von Kupfer erfolgt generell bis in eine Schichtdicke von zumindest 30 nm, bevorzugt zumindest 50 nm, zumindest 70 nm, zumindest 80 nm oder zumindest 90 nm, bis zu 200 nm, bevorzugt bis zu 150 nm oder bis zu 120 nm, z.B. 100 nm.

Das Aufsputtern von Blei in Schritt b) erfolgt bevorzugt durch Magnetronsputtern, z.B. durch Hochleistungsimpulsmagnetronsputtern (HIPIMS). Denn es hat sich gezeigt, dass durch Magnetronsputtern, insbesondere durch HIPIMS, die Ausbildung von das Analyseverfahren beeinträchtigenden Oxiden an der Bleioberfläche verringert wird. Dabei ist vorzugsweise die angelegte Leistung eine Leistung von zumindest 5 W, bevorzugt zumindest 6 W, zumindest 7 W, zumindest 8 W oder zumindest 9 W, bis zu 20 W, bevorzugt bis zu 18 W, bis zu 16 W, bis zu 14 W, oder bis zu 12 W, z.B. 10 W. Weiter ist bevorzugt der angelegte Vakuumdruck ein Druck von maximal 5 Pa, bevorzugt maximal 3 Pa, maximal 2 Pa oder maximal 1,5 Pa, jedenfalls zumindest 0,001 Pa, z.B. 1,2 Pa. Das Sputtern ist dabei vorzugsweise ein statisches Gleichstrombeschichten. Das Aufsputtern von Blei erfolgt generell bis in eine Schichtdicke von zumindest 100 nm, bevorzugt zumindest 120 nm, zumindest 140 nm, zumindest 160 nm oder zumindest 180 nm, bis zu 350 nm, bevorzugt bis zu 300 nm oder bis zu 250 nm, z.B. 200 nm.

Optional kann anschließend an das Aufsputtern in einem weiteren Schritt c) der zumindest eine beschichtete Träger im Vakuum oder in einer Inertatmosphäre angeordnet und darin bis zur weiteren Verwendung gelagert werden. Dazu kann beispielsweise der zumindest eine beschichtete Träger in einen Behälter angeordnet werden und der Behälter kann mit Vakuum beaufschlagt und luftdicht verschlossen werden. Eine Inertatmosphäre kann Stickstoff (N₂) und/oder zumindest ein Edelgas, z.B. Argon (Ar) und/oder Xenon (Xe), aufweisen oder daraus bestehen. Der Behälter kann Kunststoff- und/oder Aluminiumverbundfolie aufweisen oder daraus bestehen.

Ein mit dem Verfahren hergestellter beschichteter Träger weist zumindest eine darauf aufgesputterte Metallschicht aus Silber, Kupfer oder Blei auf, bevorzugt zumindest zwei in getrennte und voneinander beabstandete Abschnitte aufgesputterte Schichten aus voneinander verschiedenen Metallen, z.B. in einem ersten Abschnitt eine Kupferschicht, in einem davon beabstandeten zweiten Abschnitt eine Silberschicht, optional in einem davon beabstandeten dritten Abschnitt eine Bleischicht. Dabei weisen die einzelnen Metallschichten, unabhängig voneinander oder gleich, vorzugsweise eine Dicke von zumindest 50 nm bis zu 350 nm auf.

Die auf dem beschichteten Träger angeordnete Silberschicht weist bevorzugt zumindest ein Haftvermögen der Kategorie "gut" auf, ermittelt durch Tape-Test gemäß DIN EN ISO 2409, weiter bevorzugt eine Dichte von zumindest 9,88 g/cm³, ermittelt durch Röntgenreflektometriemessung (XRR), weiter bevorzugt einen spezifischen Widerstand von maximal 1 x 10⁻⁷ Ωm, bevorzugt maximal 5 x 10⁻⁸ Ωm gemessen durch Vier-Spitzen-Messung, sowie eine homogene Kristallinität, gemessen durch Röntgendiffraktometriemessung (XRD) bei einer (111)-Orientierung von 38,4° mit einer Abweichung von maximal ± 0,1°.

Die auf dem beschichteten Träger angeordnete Kupferschicht weist bevorzugt ein Haftvermögen von zumindest "gut-mittel" auf, ermittelt durch Tape-Test gemäß DIN EN ISO 2409, weiter bevorzugt eine Dichte von zumindest 6,9 g/cm³, ermittelt durch Röntgenreflektometriemessung (XRR), weiter bevorzugt einen spezifischen Widerstand von maximal 1 x 10⁻⁷ Ωm, bevorzugt maximal 4,8 x 10⁻⁸ Ωm, gemessen durch Vier-Spitzen-Messung, sowie eine homogene Kristallinität, gemessen durch Röntgendiffraktometriemessung (XRD) bei einer (111)-Orientierung von 43,6° mit einer Abweichung von maximal ± 0,1°.

Die auf dem beschichteten Träger angeordnete Bleischicht weist bevorzugt ein Haftvermögen von zumindest "gut" auf, ermittelt durch Tape-Test gemäß DIN EN ISO 2409, weiter bevorzugt eine Dichte von zumindest 11,17 g/cm³, ermittelt durch Röntgenreflektometriemessung (XRR), weiter bevorzugt einen spezifischen Widerstand von maximal 1 x 10⁻⁶ Ωm, bevorzugt maximal 5,89 x 10⁻⁷ Ωm, gemessen durch Vier-Spitzen-Messung, sowie eine homogene Kristallinität, gemessen durch Röntgendiffraktometriemessung (XRD) bei einer (111)-Orientierung von 31,18° mit einer Abweichung von maximal ± 0,1°.

Die erfindungsgemäß aufgesputterten Metallschichten können z.B. dadurch von herkömmlichen, z.B. aufgedampften, Metallschichten, wie sie z.B. aus Park et al., Solar Energy Materials 13, 351-365 (1986) bekannt sind, unterschieden werden, dass sie aufgrund ihrer homogenen Kristallstruktur stärker mit reaktiven Verbindungen reagieren und gleichzeitig weniger stark mit z.B. atmosphärischem Sauerstoff reagieren. Insbesondere zeichnen sich die erfindungsgemäß aufgesputterten Metallschichten gegenüber aufgedampften Schichten durch eine höhere Dichte aus.

Die Erfindung wird nun genauer anhand von Beispielen und im Hinblick auf die Figuren beschrieben, die in
- Fig. 1 ein Messdiagramm einer Röntgenreflektometriemessung,
- Fig. 2 eine rasterelektronenmikroskopische Aufnahme einer erfindungsgemäßen Silberschicht,
- Fig. 3 Messdaten von Röntgendiffraktometriemessungen an Silber- und Kupferschichten,
- Fig. 4 Messdaten von Röntgendiffraktometriemessungen an Bleischichten,
- Fig. 5 Messdiagramme einer elektrischen Widerstandsmessung an Silber- und Kupferschichten,
- Fig. 6 rasterelektronenmikroskopische Aufnahmen einer Silberschicht,
- Fig. 7 rasterelektronenmikroskopische Aufnahmen einer Kupferschicht,

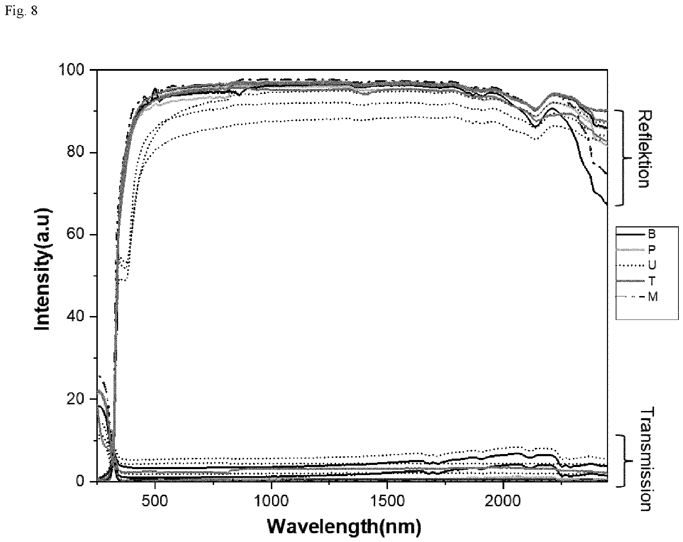

- Fig. 8 UV/Vis-Spektren von Metallschichten,
- Fig. 9 in A die mikroskopische Aufnahme einer Kupferschicht und in B eines herkömmlichen Kupferindikators, jeweils nach Lagerung mit einem für die Lagerung mit Kulturgütern ungeeigneten Material,
- Fig. 10 in A die mikroskopische Aufnahme einer Silberschicht und in B eines herkömmlichen Silberindikators, jeweils nach Lagerung mit einem für die Lagerung mit Kulturgütern ungeeigneten Material,
- Fig. 11 in A die mikroskopische Aufnahme einer Silberschicht und in B eines herkömmlichen Silberindikators, jeweils nach Lagerung mit einem für die Lagerung mit Kulturgütern zeitweise geeigneten Material,
- Fig. 12 in A die mikroskopische Aufnahme einer Bleischicht und in B eines herkömmlichen Bleiindikators, jeweils nach Lagerung mit einem für die Lagerung mit Kulturgütern zeitweise geeigneten Material
zeigen.

### Beispiel 1: Herstellung von mit Silber und Kupfer beschichtetem Träger

Es wurde ein erster Träger aus Borosilikatglas (Corning ^{®} Eagle XG ^{®}; Hans Weidner GmbH) Glasträger einer Breite von 25 mm, einer Länge von 25 mm und einer Dicke von 1,1 mm bereitgestellt. Der erste Träger wies eine Bohrung von 5 mm Durchmesser auf.

Auf den ersten Träger wurde in einer Hohlkathoden-Gasflusssputteranlage mit einer Pulsquelle (TruPlasma DC 4010, Trumpf Huettinger GmbH & Co. KG) nacheinander Silber und Kupfer in getrennte, voneinander beabstandete Abschnitte, die jeweils eine Breite von 10 mm und eine Länge von 20 mm aufwiesen, aufgesputtert, um einen beschichteten ersten Träger herzustellen. Das Aufsputtern erfolgte für Silber und Kupfer jeweils durch dynamische Beschichtung im Puls-Modus bei einer Pulsfrequenz von 100 kHz, einer Reverse-Spannung von 100 V und einem Pulsunterbrechungszeitraum ("pause time") von 2 µs, wobei ein Vakuumdruck von 33 Pa anlag. Das Aufsputtern von Silber erfolgte bei einer angelegten Leistung von 350 W bis in eine Schichtdicke von 200 nm, das Aufsputtern von Kupfer erfolgte bei einer angelegten Leistung von 500 W bis in eine Schichtdicke von 100 nm.

Zusätzlich wurde ein zweiter Träger bereitgestellt, der sich nur dadurch vom ersten Träger unterschied, dass er eine Breite von 12,5 mm aufwies. Auf den zweiten Träger wurde in einer Magnetron-Sputteranlage (Typ Z400, Leybold GmbH) in einen Abschnitt einer Breite von 12,5 mm und einer Länge von 20 mm Blei aufgesputtert, um einen beschichteten zweiten Träger herzustellen. Das Aufsputtern erfolgte durch statisches Gleichstrombeschichten bei einer angelegten Leistung von 10 W und einem Vakuumdruck von 1,2 Pa bis in eine Schichtdicke von 200 nm.

Das Haftvermögen der Metallschichten an den Trägern wurde in Anlehnung an den Tape-Test nach DIN EN ISO 2409 geprüft. Dabei zeigte sich, dass die Metallschichten ein mittleres bis gutes Haftvermögen an dem Träger aufwiesen, gezeigt durch den optisch geringen Verlust der Schichten nach ruckartigem Entfernen des Klebebands. Ein Gitterschnitt durch die aufgesputterten Schichten wurde vor dem Abziehen des Klebebands nicht erzeugt.

Es zeigte sich, dass die aufgesputterte Bleischicht eine gute Haftung aufwies. Dagegen hafteten die aufgesputterten Kupfer- und Silberschichten unterschiedlich gut. Im Detail zeigte sich, dass im statischen Feld aufgesputterte Metallschichten im Vergleich zu dynamisch aufgesputterten schlechter haften, wohingegen die im Puls-Modus aufgesputterten Metallschichten eine bessere Haftung aufwiesen als die in einem Parallelversuch mit Gleichstrom aufgesputterten Metallschichten. Gut haftende Schichten können demnach im Puls-Modus und im dynamischen Beschichtungsmodus hergestellt werden.

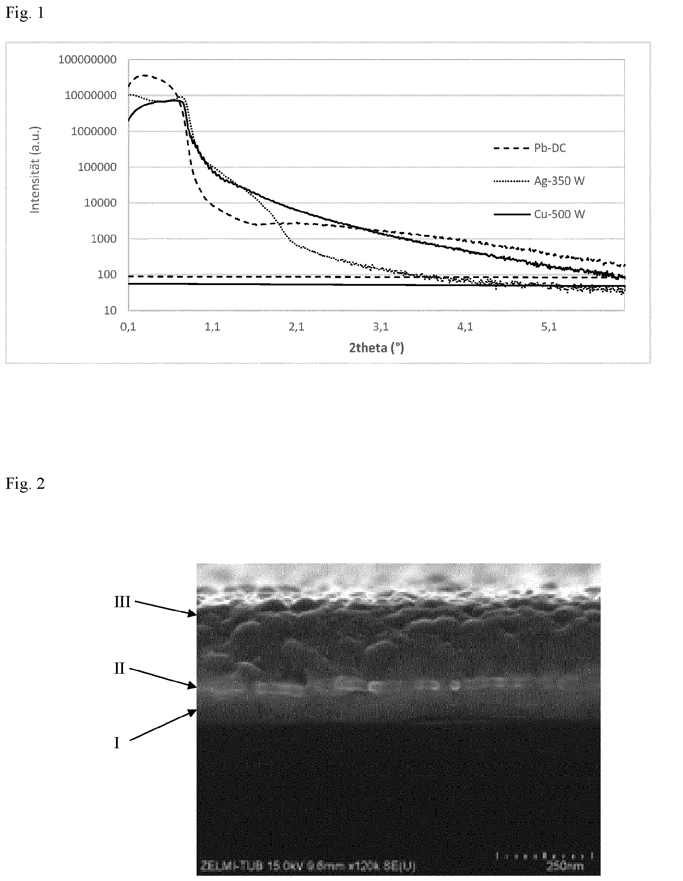

Über eine Dichtemessung mittels Röntgenreflektometrie (XRR) wurde außerdem die Homogenität der aufgesputterten Metallschichten geprüft, die Messergebnisse sind in Fig. 1 gezeigt. Dabei ergab sich, dass die mit dem Verfahren erzeugten Metallschichten von Silber und Kupfer eine Dichte von 9,88 g/cm³ bzw. 6,9 g/cm³ aufwiesen, die Bleischicht eine Dichte von 11,17 g/cm³. Die Metallschichten waren homogen und glatt.

Die Struktur der aufgesputterten Metallschichten wurde durch rasterelektronenmikroskopische Aufnahmen untersucht. Fig. 2 zeigt exemplarisch die Struktur der aufgesputterten Silberschicht im Querschnitt, die (I) eine thermalisierte poröse Teilschicht, (II) eine mit Plasmaaktivierung dichte Teilschicht und (III) eine weitere poröse Teilschicht aufweist.

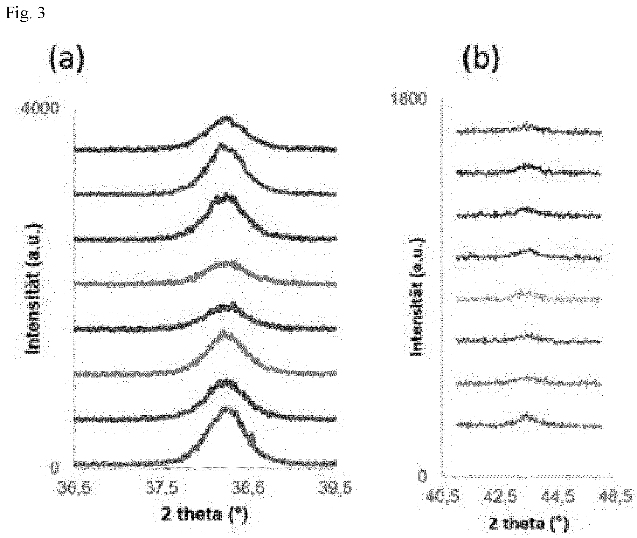

Die Metallschichten wurden außerdem mittels Röntgendiffraktometrie (XRD) auf ihre Homogenität geprüft. Dazu wurde jeweils an 8 Punkten einer Metallschicht eine Messung durchgeführt und die Messergebnisse verglichen. Fig. 3 zeigt die Messdaten.

Es zeigte sich, dass an allen 8 Messpunkten die Silberschicht eine übereinstimmende Kristallinität in der (111)-Orientierung bei einem 2Θ-Wert von 38,4° aufwies (Fig. 3 a), und die Kupferschicht eine übereinstimmende Kristallinität in der (111)-Orientierung bei einem 2Θ-Wert von 43,6° aufwies (Fig. 3 b).

Das Experiment zeigt, dass die untersuchten Metallschichten über die gesamte Fläche eine im Wesentlichen homogene Kristallinität und Struktur aufwiesen.

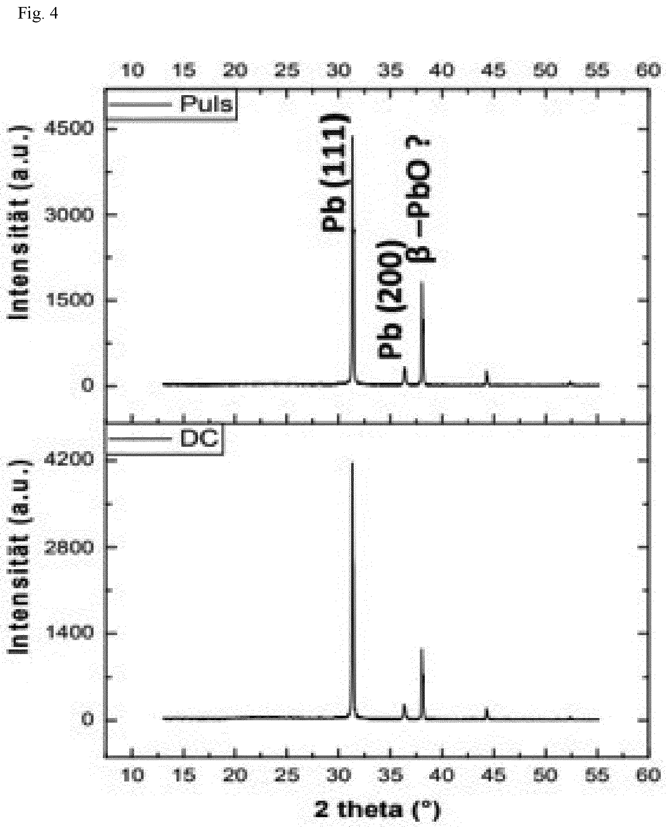

Mittels Magnetronsputtern hergestellte Bleischichten wurden mittels XRD analysiert und dabei eine mit statischem Gleichstrom aufgesputterte Bleischicht mit einer durch gepulstes Aufsputtern erzeugten Bleischicht verglichen. Fig. 4 zeigt die Messdaten.

Im oberen Bereich der Fig. 4 ist eine durch gepulstes Aufsputtern erzeugte Bleischicht gezeigt ("Puls"), im unteren Teil der Fig. 4 die erfindungsgemäß mit statischem Gleichstrom aufgesputterte Bleischicht ("DC"). Dabei wurden für beide Bleischichten jeweils Peaks bei 2Θ-Werten von ca. 32°, ca. 36,5° und ca. 38° beobachtet. Der Peak bei ca. 32° zeigt Blei in (111)-Orientierung, der Peak bei ca. 36,5° zeigt Blei in der (200)-Orientierung, der Peak bei ca. 38° zeigt Bleioxid. Dabei ist der Bleioxid-Peak nach Erzeugung der Bleischicht im Gleichstromverfahren ("DC") deutlich geringer als der entsprechende Peak der durch gepulstes Aufsputtern erzeugten Bleischicht.

Das Experiment zeigt, dass mit dem erfindungsgemäßen Aufsputtern im Gleichstromverfahren eine Bleischicht erzeugt wird, die weniger Bleioxid aufweist als eine mit herkömmlichen Verfahren erzeugte Bleischicht.

### Beispiel 2: Analyse von Materialien

Die in Beispiel 1 hergestellten beschichteten ersten Träger und beschichteten zweiten Träger wurden jeweils in getrennte Reaktionsgefäße, wie sie als Reaktionsbehälter aus der EP 3 620 232 B1 bekannt sind, eingesetzt. Als Reaktionszusatz wurde destilliertes Wasser in das Reaktionsgefäß gefüllt. Als Probe war jeweils eine von (1) Gummiwerkstoff "gikoZell ZGA", (2) PVC-Hartschaum "Forex classic", (3) Spinnvlies "Tyvek Soft Vlies", (4) schwarzer EDPM-Moosgummi, oder (5) PUR Hartschaum "KAPA Line" in dem Reagenzröhrchen des Reaktionsgefäßes eingesetzt, sowie jeweils Reaktionsgefäße ohne Stoffprobe als Blindproben vorbereitet. Für jeden zu analysierenden Stoff wurden 3 Replikate angefertigt. Zusätzlich wurden, jeweils in separaten Reaktionsgefäßen, Proben der Materialien (4) und (5) mit der Silberschicht bzw. der Kupferschicht eines beschichteten Trägers kontaktiert. Jeder der beschichteten Träger war im Bereich seiner Silberschicht und/oder Kupferschicht mit zwei Elektroden zur Messung des spezifischen Widerstands kontaktiert. Die Reaktionsgefäße wurden verschlossen und für 30 d bei 60 °C gelagert.

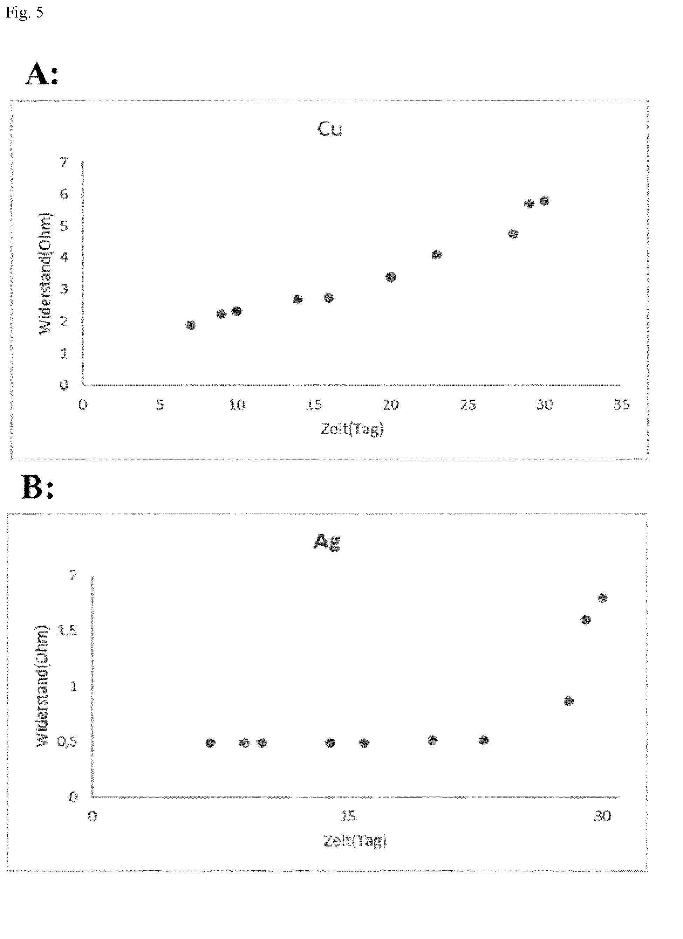

Nach 7 d, 9 d, 10 d, 14 d, 16 d, 20 d, 23 d, 28 d, 29 d und 30 d wurden jeweils Messwerte des elektrischen Widerstands der auf einem beschichteten Träger angeordneten Kupferschicht und Silberschicht aufgenommen. Fig. 5 zeigt beispielhaft für die Probe (4) in A) die Messwerte für die Kupferschicht, in B) die Messwerte für die Silberschicht. Eine Erhöhung des Messwerts für den elektrischen Widerstand zeigt dabei eine Erhöhung der Oxidation durch Fortschreiten der Korrosion der jeweiligen Metallschicht an.

Fig. 5 zeigt in A), dass der elektrische Widerstand der Kupferschicht über den Lagerungszeitraum von 30 d annähernd gleichmäßig zunahm. Der Fig. 5 B) ist zu entnehmen, dass der elektrische Widerstand der Silberschicht bis 23 d im Wesentlichen konstant blieb und danach sprunghaft anstieg.

Das Experiment zeigt, dass die aufgesputterte Kupferschicht ein bereits nach ca. 9 Tagen eintretendes, gleichmäßiges Fortschreiten der Korrosion zeigte, während die Silberschicht erst nach Ablauf von Woche 3 des Lagerns korrodierte. Das analysierte Material (4) ist aufgrund der gezeigten Messergebnisse für die Lagerung mit Kulturgütern ungeeignet.

Nach Ablauf der Reaktionszeit wurden die Reaktionsbehälter geöffnet, die beschichteten Träger entnommen und optisch mittels einer Mikroskopkamera (Axiocam 105 color, Carl Zeiss AG) im Dunkelfeld analysiert. Dabei wurde festgestellt, dass die beschichteten Träger, die mit ungeeigneten Materialien gelagert worden waren, durchsichtige, d.h. korrodierte Metallschichten aufwiesen oder die Metallschicht zumindest teilweise vom Träger verschwunden war. Im Gegensatz dazu wiesen mit ungeeigneten Materialien gelagerte beschichtete Träger, ebenso wie die beschichteten Träger der Blindprobe, undurchsichtige, d.h. nicht korrodierte Metallschichten auf. Im Vergleich zu herkömmlichen Metallindikatoren waren bei den erfindungsgemäß beschichteten Trägern korrodierte Metallschichten besser von nicht korrodierten Metallschichten unterscheidbar. Dies wird gegenwärtig auf die geringere Dicke der erfindungsgemäßen Metallschichten zurückgeführt.

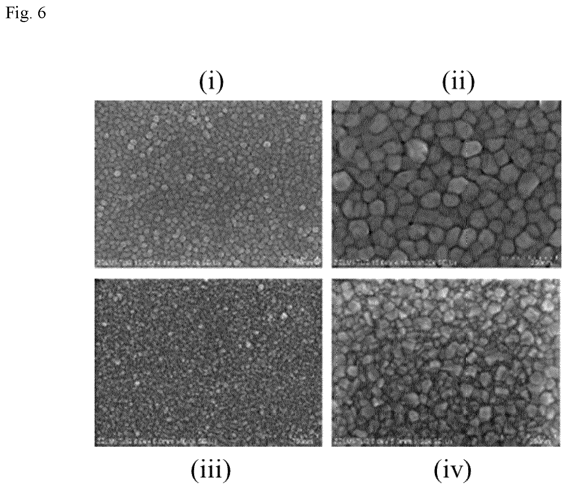

Außerdem wurden die Metallschichten durch rasterelektronenmikroskopische (REM) Aufnahmen untersucht. Die Fig. 6 zeigt in A) vergleichende Aufnahmen der Silberschicht vor Durchführung des Analyseverfahrens in (i) und (ii), sowie nach Durchführung des Analyseverfahrens in (iii) und (iv). Die Aufnahmen (i) und (iii) zeigen jeweils eine Vergrößerung von 25.000x, die Aufnahmen (ii) und (iv) jeweils eine Vergrößerung von 120.000x. Dabei zeigte sich, dass nach Abschluss des Analyseverfahrens die Silberschicht kleinere Kristalle aufwies als im Vorfeld des Analyseverfahrens. Diese Veränderung wird gegenwärtig darauf zurückgeführt, dass die Kristalle durch Korrosion während des Analyseverfahrens angegriffen und damit zersetzt wurden.

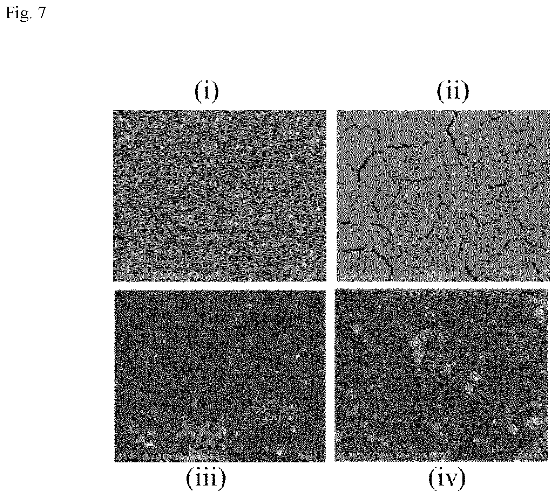

Die Fig. 7 zeigt in A) vergleichende Aufnahmen der Kupferschicht vor Durchführung des Analyseverfahrens in (i) und (ii), sowie nach Durchführung des Analyseverfahrens in (iii) und (iv). Die Aufnahmen (i) und (iii) zeigen jeweils eine Vergrößerung von 25.000x, die Aufnahmen (ii) und (iv) jeweils eine Vergrößerung von 120.000x. Dabei zeigte sich, dass im Vorfeld des Analyseverfahrens die Kupferschicht eine mit Rissen durchzogene Oberfläche zeigte. Nach Abschluss des Analyseverfahrens waren die Risse an der Kupferschicht stärker ausgebildet als zu Beginn des Analyseverfahrens, und die Kristallinität wies starke Änderungen auf, was z.B. durch Kontamination der analysierten Probe verursacht sein könnte.

Eingesetzte Silberschichten (Ag) und Kupferschichten (Cu) wurden nach Abschluss des Analyseverfahrens zusätzlich ellipsometrisch untersucht. Die Berechnung der Schichtdicke und des Widerstands erfolgte mittels eines 2-Schichten-Modells, wobei modellgemäß auf dem Träger eine erste Schicht (S1) mit größerer Dicke (d) und geringem elektrischen Widerstand (ρ) angeordnet ist und darauf eine zweite Schicht (S2) mit einer geringeren Dicke (d) und einem hohen elektrischen Widerstand (ρ) angeordnet ist. Das 2-Schichten-Modell wurde trotz der im Rasterelektronenmikroskop beobachteten 3 Schichten für angemessen erachtet, da sich hiermit die oberen korrodierten Bereiche als Modell berechnen lassen. Aus den Messdaten wurden anhand des Modells die effective medium approximation ("EMA_d"), die zu 50% von der oberen Schicht (S2) und 50% Luft, die Rauigkeit der Schicht bestimmt, sowie die mean square error (MSE) abgeleitet, dadurch wird die Abweichung zwischen dem gemessenen und dem modellierten Spektrum den MSE-Wert ausgedrückt.

Die Proben Ag211006-37 und Cu211006-37 wurden vor Beginn des Analyseverfahrens untersucht. Die Proben Ag-M37, Ag-M38, Ag-M39, Ag-M40, Cu-M37, Cu-M38, Cu-M39 und Cu-M40 wurden nach Abschluss des Analyseverfahrens untersucht, wobei diese Proben mit dem Material "Tyvek Soft Vlies" gelagert wurden, das für den Einsatz in der Umgebung von Kulturgütern geeignet ist. Die Proben Ag-M43, Ag-M44, Ag-M45, Ag-M46, Cu-M43, Cu-M44, Cu-M45 und Cu-M46 wurden nach Abschluss des Analyseverfahrens untersucht, wobei diese Proben mit dem Material "gikoZell ZGA" gelagert wurden, das für den Einsatz in der Umgebung von Kulturgütern ungeeignet ist. Die Proben Ag-M49, Ag-M50, Ag-M51, Ag-M52, Cu-M49, Cu-M50, Cu-M51 und Cu-M52 wurden nach Abschluss des Analyseverfahrens untersucht, wobei diese Proben mit dem Material "Forex classic" gelagert wurden, die für den Einsatz in der Umgebung von Kulturgütern nur temporär geeignet ist.

Die nachfolgende Tabelle zeigt die Messwerte der Ellipsometrie-Messung den berechneten spezifischen Widerstand.

| **Ag** | **S1: d[nm]** | **S1: ρ[µΩm]** | **S2: d[nm]** | **S2: ρ[µΩm]** | **EMA_d[nm]** | **MSE** |
|---|---|---|---|---|---|---|
| **Ag211006-37** | 193,82 | 0,23238038 | 18,15 | 1316,37277 | 1,7 | 1,81 |
| **Ag-M37** | 221,96 | 0,72896529 | 19,42 | 1476,7772 | 4,6 | 1,82 |
| **Ag-M38** | 218,01 | 0,55949894 | 31,91 | 80234,1875 | 0,55 | 1,72 |
| **Ag-M39** | 184,8 | 0,66467204 | 22,77 | 4661,48115 | 0,58 | 2,18 |
| **Ag-M40** | 174,15 | 0,5482762 | 24,82 | 2464,90442 | 9,01 | 1,66 |
| **Ag-M43** | 182,85 | 1,90316581 | 15,71 | 382,725457 | 6,39 | 8,9 |
| **Ag-M44** | 236,86 | 0,00569591 | 65,93 | 8296553,56 | 150 | 7,67 |
| **Ag-M45** | 239,81 | 0,74248051 | 9,99 | 120,36527 | 8,87 | 4,2 |
| **Ag-M46** | 174,86 | 0,79851812 | 28,44 | 5529,84032 | 67,71 | 8,63 |
| **Ag-M49** | 214,23 | 0,45031737 | 34,98 | 0,00249948 | 0,08 | 1,66 |
| **Ag-M50** | 152,66 | 0,32292875 | 17,47 | 2304,54305 | 4,02 | 1,27 |
| **Ag-M51** | 226,03 | 0,48041432 | 25,96 | 15511,194 | 0,24 | 1,26 |
| **Ag-M52** | 179,3 | 0,45225801 | 13,57 | 3365,88289 | 21,21 | 1,28 |

| **Cu** | **S1: d[nm]** | **S1: ρ[µΩm]** | **S2: d[nm]** | **S2: ρ[µΩm]** | **EMA_d[nm]** | **MSE** |
|---|---|---|---|---|---|---|
| **Cu211006-37** | 75,4 | 0,7158118 | 0,43 | 323,74747 | 15,44 | 2,18 |
| **Cu-M37** | 71,07 | 80,286698 | 42,12 | 178,663436 | 24,56 | 5,28 |
| **Cu-M38** | 53,41 | 33,8050148 | 42,17 | 61,3667287 | 8,69 | 6,32 |
| **Cu-M39** | 53,6 | 208,651219 | 41,5 | 68,6917141 | 12,99 | 9,05 |
| **Cu-M40** | 82,54 | 146,023694 | 50,07 | 418,091492 | 16,66 | 6,41 |
| **Cu-M43** | 59,51 | 1947,57569 | 35,38 | 35,6786294 | 8,9 | 4,36 |
| **Cu-M44** | 49,75 | 1,49567809 | 31,12 | 412,01618 | 26,47 | 9,56 |
| **Cu-M45** | 58,88 | 0,04236385 | 20,2 | 21,6199555 | 10,81 | 9,79 |
| **Cu-M46** | 14,98 | 0,00268707 | 66,61 | 0,01114048 | 0,81 | 5,71 |
| **Cu-M46_Punkt** | 50,52 | 17,0497637 | 43,11 | 60,26416 | 8,85 | 2,2 |
| **Cu-M49** | 28,12 | 2,10238572 | 14,47 | 6,38841489 | 7,84 | 3,75 |
| **Cu-M50** | 46,29 | 1,5756E-05 | 59,11 | 3123,73175 | 0 | 21,6 |
| **Cu-M51** | 92,34 | 4,81501795 | 70,19 | 8396,77909 | 0 | 8,39 |
| **Cu-M52** | 109,36 | 23957,14 | 17,85 | 742,212007 | 36,5 | 12,1 |

Die Messungen zeigen, dass nach Lagerung mit ungeeigneten Materialien höhere Werte für den spezifischen Widerstand und die Rauigkeit beobachtet wurden, was einen höheren Grad an Korrosion bedeutet. Nach Lagerung der mit den Metallschichten beschichteten Trägern mit geeigneten bzw. unbedenklichen Materialien wurden niedrigere Werte der Rauigkeit und des spezifischen Widerstands beobachtet, woraus ein geringerer Grad an Korrosion der Metallschicht angezeigt ist.

Die Silberschichten wurden vor Beginn des Analyseverfahrens und nach dem Ende des Analyseverfahrens mittels UV/Vis-Spektroskopie untersucht. Dabei wird die Extinktion des sichtbaren und ultravioletten Lichts durch Absorption, Streuung, Beugung und Reflexion gemessen, sowie die Transmission des aufgestrahlten Lichts durch die Metallschicht hindurch. Es wurden folgende Proben betrachtet:
- B: Blindprobe ohne Material,
- P: Probe eines für die Lagerung mit Kulturgütern geeigneten Materials,
- U: Probe eines für die Lagerung mit Kulturgütern ungeeigneten Materials,
- T: Probe eines für die Lagerung mit Kulturgütern nur temporär geeigneten Materials,
- M: beschichteter Träger, der nicht mit dem Verfahren behandelt wurde.

Von jeder Probe wurde ein Lichtspektrum der Wellenlängen zwischen 25 nm und 2500 nm aufgenommen, wobei jeweils die Transmission (Linien im unteren Bildteil) und Reflexion (Linien im oberen Bildteil) bestimmt wurden. Dabei wurde beobachtet, dass Metallschichten, die mit ungeeigneten Materialien gelagert worden waren, in dem Wellenlängenbereich zwischen ca. 200 nm und 1800 nm eine geringere Reflektion und eine höhere Transmission aufwiesen als die Metallschichten nach Lagerung mit geeigneten Materialien bzw. der Blindprobe. Die Messergebnisse zeigen, dass stärker korrodierte Metallschichten dadurch von nicht korrodierten Metallschichten unterschieden werden können, dass sie eine höhere Transmission und niedrigere Reflektion im UV-Vis-Spektrum aufweisen.

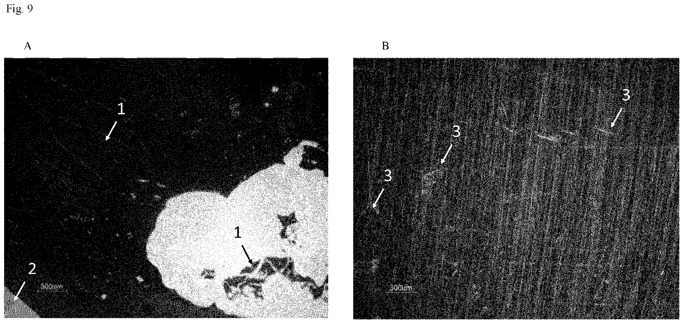

In einem weiteren Versuch wurde ein Analyseverfahren mit herkömmlichen, durch Zuschneiden reiner Metallstreifen hergestellten Indikatoren durchgeführt, wie sie zur Verwendung im Oddy-Test bekannt sind. Die Indikatoren wurden jeweils in getrennte Reaktionsgefäße, wie sie als Reaktionsbehälter aus der EP 3 620 232 B1 bekannt sind, eingesetzt. Als Reaktionszusatz wurde destilliertes Wasser in das Reaktionsgefäß gefüllt. Als Probematerialien war (1) Gummiwerkstoff "gikoZell ZGA", (2) PVC-Hartschaum "Forex classic", oder (3) Spinnvlies "Tyvek Soft Vlies" in dem Reaktionsgefäß enthalten. Die Reaktionsgefäße wurden verschlossen und für 28 d bei 60 °C gelagert. Der Versuch wurde 3x wiederholt, jeweils im Vergleich mit erfindungsgemäßen beschichteten Trägern. Die Auswertung erfolgte durch Aufnahme von Bildern mit einer Mikroskopkamera (Axiocam 105 color, Carl Zeiss AG) im Dunkelfeld. In den in Fig. 9-12 gezeigten Aufnahmen ist jeweils der Maßstab angezeigt.

Die in den drei Replikaten des Vergleichsversuchs eingesetzten Metallindikatoren waren nach dem Lagern bis auf wenige Ausreißer vergleichbar. Die mit den herkömmlichen Metallindikatoren erhaltenen Korrosionsbilder waren mit denen der erfindungsgemäßen beschichteten Träger vergleichbar, weshalb eine optische Bewertung der Metallschichten mit dem bekannten Ampelsystem möglich war. Es waren allerdings auch leichte Abweichungen u.a. am Silber, insbesondere nach Lagerung mit dem für die zeitweise Lagerung geeigneten Material Forex classic, zu erkennen. Derartige leichte Verfärbungen sind nach Lagerung mit zeitweise geeigneten Materialien üblich und als Ergebnis des Analyseverfahrens erwünscht. Kupfer wies nach Lagerung mit einem für die Lagerung mit Kulturgütern geeigneten Material starke Verdunklungen auf und Blei entwickelte eine Transparenz.

Die mikroskopischen Untersuchungen der Kupferschicht (Fig. 9a) zeigen Verdunklungen (Pfeile 1), welche durch Schwefelverbindungen aus dem zur Lagerung ungeeigneten Gummiwerkstoff gikoZell ZGA herrühren. Außerdem weist die linke untere Ecke kein Metall mehr auf (Pfeil 2), was vermutlich auf eine zu geringe Schichtstärke zurückzuführen ist. Der herkömmliche Metallindikator aus reinem Kupfer (Fig. 9b) weist ebenfalls Korrosionsspuren (Pfeile 3) auf, die freilich schlechter erkennbar sind als die der erfindungsgemäß hergestellten Kupferschicht.

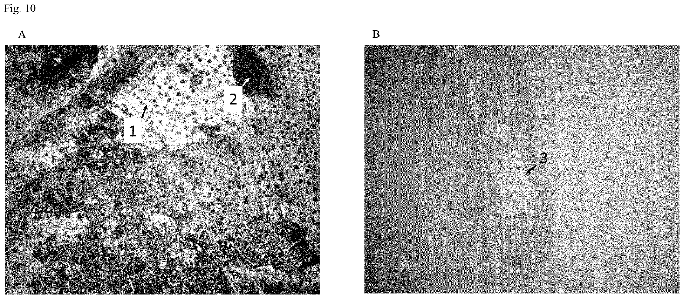

Die mikroskopischen Aufnahmen der Silberschicht (Fig. 10a) zeigen ebenfalls flächige Verfärbungen (Pfeil 1). Wie beim Kupfer ist die Verfärbung des Silbers auf die Schwefelverbindung (Silbersulfid) des Gummiwerkstoffs gikoZell ZGA zurückzuführen. Das Auflösen der Metallschicht hat ebenfalls begonnen (Pitting; Pfeil 2). Im Gegensatz dazu ist an einem herkömmlichen Silberindikator, dessen mikroskopische Aufnahme Fig. 10b zeigt, nach Inkubation mit gikoZell ZGA nur eine leichte Verfärbung sichtbar (Pfeil 3).

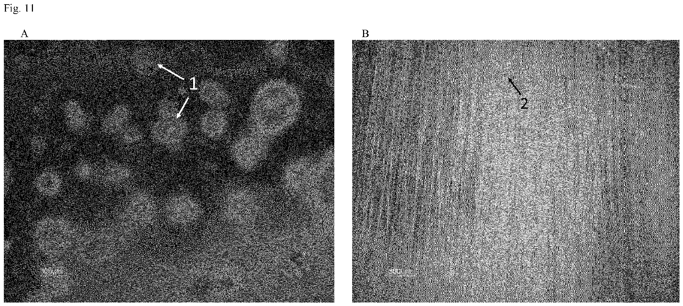

Als temporär für die Lagerung mit Kulturgütern geeignetes Probematerial wurde die PVC-Hartschaumplatte Forex classic eingesetzt. Die in diesem Material enthaltenen Chloridverbindungen werden mit den gelb-grünlichen Korrosionen an der erfindungsgemäßen Kupferschicht (Fig. 11a: Pfeil 1) in Verbindung gebracht. Im Vergleich dazu treten an einem herkömmlichen Kupferindikator (Fig. 11b) nur schlecht sichtbare Verfärbungen auf (Pfeil 2).

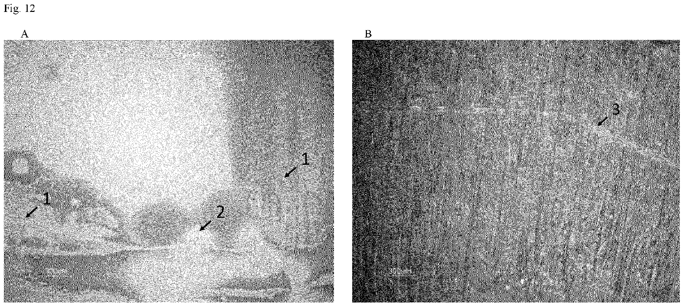

Die nach der Lagerung mit Forex classic angefertigten mikroskopischen Aufnahmen der erfindungsgemäß aufgesputterten Bleischichten (Fig. 12a) zeigen mehrheitlich helle, opake Bereiche (Pfeile 1). Es handelt sich dabei um Oxidschichten. In Anwesenheit von Schwefel bildet sich zudem Bleisulfid. In den weißen opaken Bereichen (Pfeil 2) ist kein Metall mehr vorhanden. Ein herkömmlicher Bleiindikator (Fig. 12b) wies nach der Lagerung mit Forex classic schwer erkennbare korrodierte Stellen auf (Pfeil 3). Das Beispiel 2 zeigt, dass das erfindungsgemäße Analyseverfahren mit den gemäß Beispiel 1 hergestellten beschichteten Trägern durchgeführt werden kann. Die Ergebnisse des Analyseverfahrens, das mit den erfindungsgemäßen beschichteten Trägern durchgeführt wurde, waren reproduzierbar und eindeutig, und bestätigten das für die analysierten Materialien bereits bekannte Korrosionsverhalten der Metallindikatoren im Oddy-Test.

Der Vergleichsversuch zeigt, dass mit den im erfindungsgemäßen Verfahren erhaltenen beschichteten Trägern ein Materialanalyseverfahren durchgeführt werden kann, wobei die Ergebnisse reproduzierbarer sind als mit herkömmlichen Indikatoren und die durch die Lagerung erzeugte Korrosion der Metallschichten leichter erkennbar ist.

## Patentansprüche

1. Verfahren zur Materialanalyse mit den Schritten
a) Bereitstellen zumindest eines mit Silber und/oder Kupfer und/oder Blei beschichteten Trägers,
b) Anordnen des zumindest einen beschichteten Trägers in einem das zu analysierende Material enthaltenden Reaktionsgefäß, mit luftdichtem Verschließen des Reaktionsgefäßes,
c) Lagern des zumindest einen beschichteten Trägers in dem luftdicht verschlossenen Reaktionsgefäß bei 60 °C für 10 bis 40 Tage, und
d) Analysieren des zumindest einen beschichteten Trägers auf Veränderungen,
wobei der zumindest eine beschichtete Träger durch Aufsputtern beschichtet ist, wobei das Silber durch dynamisches Beschichten im Puls-Modus durch Gasflusssputtern mit einer angelegten Leistung von 300-400 W, einem angelegten Vakuumdruck von 10-50 Pa, einer Pulsfrequenz von 10-200 kHz, einer Reverse-Spannung von 25-125 V und einem Pulsunterbrechungszeitraum von 0,5-4 µs aufgesputtert ist,
wobei das Kupfer durch dynamisches Beschichten im Puls-Modus durch Gasflusssputtern mit einer angelegten Leistung von 400-600 W, einem angelegten Vakuumdruck von 10-50 Pa, einer Pulsfrequenz von 10-200 kHz, einer Reverse-Spannung von 25-125 V und einem Pulsunterbrechungszeitraum von 0,5-4 µs aufgesputtert ist, und
das Blei durch statisches Gleichstrombeschichten durch Magnetronsputtern mit einer angelegten Leistung von 5-20 W und einem angelegten Vakuumdruck von maximal 5 Pa aufgesputtert ist.

2. Verfahren nach Anspruch 1, **dadurch gekennzeichnet, dass** der beschichtete Träger Silber in einer Schichtdicke von 200 nm aufweist, Kupfer in einer Schichtdicke von 100 nm aufweist, und/oder Blei in einer Schichtdicke von 200 nm aufweist.

3. Verfahren nach einem der Ansprüche 1 bis 2, **dadurch gekennzeichnet, dass** in Schritt d) das Analysieren durch Aufnehmen eines Bilds des zumindest einen beschichteten Trägers und Vergleichen des aufgenommenen Bilds mit einer Eichkurve und/oder einer parallel mitgeführten Blindprobe und/oder einem unbehandelten beschichteten Träger erfolgt.

4. Verfahren nach einem der voranstehenden Ansprüche, **dadurch gekennzeichnet, dass** das auf dem zumindest einen beschichteten Träger angeordnete Silber eine Silberschicht ist, die ein Haftvermögen von zumindest "gut", eine Dichte von zumindest 9,88 g/cm³, einen spezifischen Widerstand von maximal 1 x 10⁻⁷ Qm, sowie eine homogene Kristallinität gemessen durch Röntgendiffraktometriemessung (XRD) bei einer (111)-Orientierung von 38,4° mit einer Abweichung von maximal ± 0,1°, aufweist,
das auf dem zumindest einen beschichteten Träger angeordnete Kupfer eine Kupferschicht ist, die ein Haftvermögen von zumindest "gut-mittel", eine Dichte von zumindest 6,9 g/cm³, einen spezifischen Widerstand von maximal 1 x 10⁻⁷ Qm, sowie eine homogene Kristallinität, gemessen durch Röntgendiffraktometriemessung (XRD) bei einer (111)-Orientierung von 43,6° mit einer Abweichung von maximal ± 0,1°, aufweist, und
das auf dem zumindest einen beschichteten Träger angeordnete Blei eine Bleischicht ist, die ein Haftvermögen von zumindest "gut", eine Dichte von zumindest 11,17 g/cm³, einen spezifischen Widerstand von maximal 1 x 10⁻⁶ Qm, sowie eine homogene Kristallinität, gemessen durch Röntgendiffraktometriemessung (XRD) bei einer (111)-Orientierung von 31,18° mit einer Abweichung von maximal ± 0,1°, aufweist.

5. Verfahren nach einem der voranstehenden Ansprüche, **dadurch gekennzeichnet, dass** der zumindest eine beschichtete Träger in einem ersten Abschnitt mit einem von Silber, Kupfer und Blei beschichtet ist, und in einem davon beabstandeten zweiten Abschnitt mit einem anderen von Silber, Kupfer und Blei beschichtet ist.

6. Verfahren zur Herstellung eines beschichteten Trägers zur Verwendung in einem Verfahren nach einem der voranstehenden Ansprüche mit den Schritten
a) Bereitstellen zumindest eines Trägers, und
b) Aufsputtern von Silber und/oder Kupfer und/oder Blei auf den zumindest einen Träger, um zumindest einen beschichteten Träger zu erzeugen,
wobei das Aufsputtern von Silber als dynamisches Beschichten im Puls-Modus durch Gasflusssputtern mit einer angelegten Leistung von 300-400 W, einem angelegten Vakuumdruck von 10-50 Pa, einer Pulsfrequenz von 10-200 kHz, einer Reverse-Spannung von 25-125 V und einem Pulsunterbrechungszeitraum von 0,5-4 µs erfolgt, das Aufsputtern von Kupfer als dynamisches Beschichten im Puls-Modus durch Gasflusssputtern mit einer angelegten Leistung von 400-600 W, einem angelegten Vakuumdruck von 10-50 Pa, einer Pulsfrequenz von 10-200 kHz, einer Reverse-Spannung von 25-125 V und einem Pulsunterbrechungszeitraum von 0,5-4 µs erfolgt, und das Aufsputtern von Blei als statisches Gleichstrombeschichten durch Magnetronsputtern mit einer angelegten Leistung von 5-20 W und einem angelegten Vakuumdruck von maximal 5 Pa erfolgt.

7. Verfahren nach Anspruch 6, **dadurch gekennzeichnet, dass** das Aufsputtern von Silber und Kupfer auf denselben Träger erfolgt, wobei das Aufsputtern von Silber in einen ersten Abschnitt des zumindest einen Trägers erfolgt und das Aufsputtern von Kupfer in einen davon beabstandeten zweiten Abschnitt desselben Trägers erfolgt.

8. Verfahren nach einem der Ansprüche 6 bis 7, **dadurch gekennzeichnet, dass** das Aufsputtern von Silber bis in eine Schichtdicke von 200 nm erfolgt, das Aufsputtern von Kupfer bis in eine Schichtdicke von 100 nm erfolgt, das Aufsputtern von Blei bis in eine Schichtdicke von 200 nm erfolgt.

9. Verfahren nach einem der Ansprüche 6 bis 8, **gekennzeichnet durch** den zusätzlichen Schritt c) Anordnen des zumindest einen beschichteten Trägers im Vakuum oder in einer Inertatmosphäre, und Lagern bis zur weiteren Verwendung.

## Claims

1. Method for material analysis comprising the steps of
a) providing at least one carrier coated with silver and/or copper and/or lead,
b) placing the at least one coated carrier in a reaction vessel containing the material to be analysed, whilst sealing the reaction vessel airtight,
c) storing the at least one coated carrier in the airtight reaction vessel at 60 °C for 10 to 40 days, and
d) analysing the at least one coated support for changes,
wherein the at least one coated carrier is coated by sputtering,
wherein the silver is deposited by dynamic coating in pulse mode via gas flow sputtering with an applied power of 300-400 W, an applied vacuum pressure of 10-50 Pa, a pulse frequency of 10-200 kHz, a reverse voltage of 25-125 V and a pulse interruption duration of 0.5-4 µs,
wherein the copper is sputtered onto the carrier by dynamic pulsed gas flow sputtering with an applied power of 400-600 W, an applied vacuum pressure of 10-50 Pa, a pulse frequency of 10-200 kHz, a reverse voltage of 25-125 V and a pulse interruption duration of 0.5-4 µs, and
the lead is sputtered onto the carrier by static direct-current coating via magnetron sputtering with an applied power of 5-20 W and an applied vacuum pressure of at maximum 5 Pa.

2. Method according to claim 1, **characterised in that** the coated carrier comprises silver with a layer thickness of 200 nm, copper with a layer thickness of 100 nm, and/or lead with a layer thickness of 200 nm.

3. Method according to any one of claims 1 to 2, **characterised in that**, in step d), the analysis is carried out by capturing an image of the at least one coated carrier and comparing the captured image with a calibration curve and/or a blank sample analysed in parallel and/or an untreated coated carrier.

4. Method according to any one of the preceding claims, **characterised in that** the silver disposed on the at least one coated carrier is a silver layer having an adhesion of at least 'good', a density of at least 9.88 g/cm³, a specific resistance of at most 1 ×10⁻⁷ Ωm, and a homogeneous crystallinity as measured by X-ray diffraction measurement (XRD) at an (111) orientation of 38.4° with a deviation of at maximum ± 0.1°,
the copper arranged on the at least one coated carrier is a copper layer which has an adhesion of at least 'good-medium', a density of at least 6.9 g/cm³, a specific resistance of at maximum 1 ×10⁻⁷ Ωm, and a homogeneous crystallinity, as measured by X-ray diffraction measurement (XRD) at an (111) orientation of 43.6° with a deviation of at maximum ± 0.1°, and
the lead arranged on the at least one coated carrier is a lead layer which has an adhesion of at least 'good', a density of at least 11.17 g/cm³, a specific resistance of at maximum 1 ×10⁻⁶ Ωm, and a homogeneous crystallinity, as measured by X-ray diffraction measurement (XRD) at an (111) orientation of 31.18°, with a deviation of at maximum ± 0.1°.

5. Method according to any one of the preceding claims, **characterised in that** the at least one coated carrier is coated in a first section with one of silver, copper and lead, and in a second section spaced apart therefrom with another of silver, copper and lead.

6. Method for producing a coated carrier for use in a method according to any one of the preceding claims, comprising the steps of
a) providing at least one carrier, and
b) sputtering silver and/or copper and/or lead onto the at least one carrier to produce at least one coated carrier,
wherein the sputtering of silver is carried out as dynamic coating in pulse mode by gas flow sputtering with an applied power of 300-400 W, an applied vacuum pressure of 10-50 Pa, a pulse frequency of 10-200 kHz, a reverse voltage of 25-125 V and a pulse interruption duration of 0.5-4 µs,
the sputtering of copper as dynamic coating in pulse mode by gas flow sputtering with an applied power of 400-600 W, an applied vacuum pressure of 10-50 Pa, a pulse frequency of 10-200 kHz, a reverse voltage of 25-125 V and a pulse interruption duration of 0.5-4 µs, and
the sputtering of lead is carried out as static direct-current coating by magnetron sputtering with an applied power of 5-20 W and an applied vacuum pressure of at maximum 5 Pa.

7. Method according to claim 6, **characterised in that** the sputtering of silver and copper is carried out onto the same carrier, wherein the sputtering of silver is carried out onto a first section of the at least one carrier and the sputtering of copper is carried out onto a second section of the same carrier spaced apart therefrom.

8. Method according to any one of claims 6 to 7, **characterised in that** the sputtering of silver is carried out to a layer thickness of 200 nm, the sputtering of copper is carried out to a layer thickness of 100 nm, and the sputtering of lead is carried out to a layer thickness of 200 nm.

9. Method according to any one of claims 6 to 8, **characterised by** the additional step c) of placing the at least one coated carrier in a vacuum or in an inert atmosphere, and storing it until further use.

## Revendications

1. Procédé d'analyse de matériaux comprenant les étapes suivantes
a) la mise à disposition d'au moins un support revêtu d'argent et/ou de cuivre et/ou de plomb,
b) la disposition dudit au moins un support revêtu dans un récipient de réaction contenant le matériau à analyser, avec fermeture hermétique dudit récipient de réaction,
c) le stockage dudit au moins un support revêtu dans le récipient de réaction fermé hermétiquement à 60 °C pendant 10 à 40 jours, et
d) analyser ce au moins un support revêtu afin de détecter d'éventuelles modifications, le moins un support revêtu étant revêtu par pulvérisation cathodique,
l'argent étant déposé par revêtement dynamique en mode pulsé par pulvérisation cathodique sous flux gazeux avec une puissance appliquée de 300 à 400 W, une pression de vide appliquée de 10 à 50 Pa, une fréquence d'impulsion de 10 à 200 kHz, une tension inverse de 25 à 125 V et une durée d'interruption d'impulsion de 0,5 à 4 µs,
le cuivre ayant été déposé par revêtement dynamique en mode pulsé par pulvérisation cathodique sous flux gazeux avec une puissance appliquée de 400 à 600 W, une pression de vide appliquée de 10 à 50 Pa, une fréquence d'impulsion de 10 à 200 kHz, une tension inverse comprise entre 25 et 125 V et une durée d'interruption d'impulsion comprise entre 0,5 et 4 µs, et
le plomb a été déposé par revêtement statique en courant continu par pulvérisation magnétron avec une puissance appliquée de 5 à 20 W et une pression de vide appliquée maximale de 5 Pa.

2. Procédé selon la revendication 1, **caractérisé en ce que** le support revêtu comporte de l'argent d'une épaisseur de couche de 200 nm, du cuivre d'une épaisseur de couche de 100 nm, et/ou du plomb d'une épaisseur de couche de 200 nm.

3. Procédé selon l'une des revendications 1 à 2, **caractérisé en ce que**, à l'étape d), l'analyse s'effectue par l'acquisition d'une image dudit au moins un support revêtu et par la comparaison de l'image acquise avec une courbe d'étalonnage et/ou un échantillon témoin suivi en parallèle et/ou un support revêtu non traité.

4. Procédé selon l'une des revendications précédentes, **caractérisé en ce que** l'argent disposé sur ledit au moins un support revêtu est une couche d'argent qui présente une adhérence d'au moins "bonne", une densité d'au moins 9,88 g/cm³, une résistivité maximale de 1 ×10⁻⁷ Ωm, ainsi qu'une cristallinité homogène mesurée par diffraction des rayons X (XRD) avec une orientation (111) de 38,4° et un écart maximal de ± 0,1° ;
le cuivre disposé sur ledit au moins un support revêtu est une couche de cuivre présentant une adhérence d'au moins "bonne à moyenne", une densité d'au moins 6,9 g/cm³, une résistivité maximale de 1 ×10⁻⁷ Ωm, ainsi qu'une cristallinité homogène, mesurée par diffraction des rayons X (DRX) avec une orientation (111) de 43,6° et un écart maximal de ± 0,1°, et
le plomb disposé sur ledit au moins un support revêtu est une couche de plomb qui présente une adhérence d'au moins "bonne", une densité d'au moins 11,17 g/cm³, une résistivité maximale de 1 ×10⁻⁶ Ωm, ainsi qu'une cristallinité homogène, mesurée par diffraction des rayons X (DRX) avec une orientation (111) de 31,18° et un écart maximal de ± 0,1°.

5. Procédé selon l'une des revendications précédentes, **caractérisé en ce que** ledit au moins un support revêtu est revêtu, dans une première partie, d'un élément choisi parmi l'argent, le cuivre et le plomb, et, dans une deuxième partie espacée de celle-ci, d'un autre élément choisi parmi l'argent, le cuivre et le plomb.

6. Procédé de fabrication d'un support revêtu destiné à être utilisé dans un procédé selon l'une des revendications précédentes, comprenant les étapes suivantes :
a) fournir au moins un support, et
b) la dépôt par pulvérisation cathodique d'argent et/ou de cuivre et/ou de plomb sur ledit au moins un support afin de produire au moins un support revêtu,
le dépôt par pulvérisation cathodique d'argent étant réalisé sous forme de revêtement dynamique en mode pulsé par pulvérisation cathodique à flux de gaz avec une puissance appliquée de 300 à 400 W, une pression de vide appliquée de 10 à 50 Pa, une fréquence d'impulsion de 10 à 200 kHz, une tension inverse de 25 à 125 V et une durée d'interruption d'impulsion de 0,5 à 4 µs,
le dépôt par pulvérisation cathodique du cuivre, en tant que revêtement dynamique en mode pulsé, est réalisé par pulvérisation cathodique à flux de gaz avec une puissance appliquée de 400 à 600 W, une pression de vide appliquée de 10 à 50 Pa, une fréquence d'impulsion de 10 à 200 kHz, une tension inverse de 25 à 125 V et d'une durée d'interruption d'impulsion de 0,5 à 4 µs, et
le dépôt de plomb s'effectue par revêtement statique en courant continu par pulvérisation magnétron avec une puissance appliquée de 5 à 20 W et une pression de vide appliquée maximale de 5 Pa.

7. Procédé selon la revendication 6, **caractérisé en ce que** la pulvérisation cathodique d'argent et de cuivre s'effectue sur le même support, la pulvérisation cathodique d'argent s'effectuant dans une première partie dudit au moins un support et la pulvérisation cathodique de cuivre s'effectuant dans une deuxième partie dudit même support, espacée de la première.

8. Procédé selon l'une des revendications 6 à 7, **caractérisé en ce que** le dépôt par pulvérisation cathodique de l'argent s'effectue jusqu'à une épaisseur de couche de 200 nm, le dépôt par pulvérisation cathodique du cuivre s'effectue jusqu'à une épaisseur de couche de 100 nm, et le dépôt par pulvérisation cathodique du plomb s'effectue jusqu'à une épaisseur de couche de 200 nm.

9. Procédé selon l'une des revendications 6 à 8, **caractérisé par** l'étape supplémentaire c) consistant à placer ledit au moins un support revêtu sous vide ou dans une atmosphère inerte, et à le stocker en vue d'une utilisation ultérieure.
